# EUROPEAN PATENT SPECIFICATION

(11) **EP 1 211 799 B1**
(45) Date of publication and mention of the grant of the patent: **25.08.2004**
(21) Application number: 99919630.6
(22) Date of filing: 18.05.1999
(51) Int. Cl.: H03B 5/12, H03B 5/18

(54) **LC OSCILLATOR**
OSZILLATOR
OSCILLATEUR LC

(43) Date of publication of application: 05.06.2002
(73) Proprietor: Niigata Seimitsu Co., Ltd., Niigata 943-0834 (JP)
(72) Inventor: OKAMOTO, Akira, Ageo-shi, Saitama 362-0015 (JP); IKEDA, Takeshi, Tokyo 143-0023 (JP)
(74) Representative: Murgatroyd, Susan Elizabeth
(86) International application number: PCT/JP1999/002567
(87) International publication number: WO 2000/070740

(56) References cited:
- EP-A- 0 661 805
- JP-A- 7 336 138
- JP-A- 10 284 691
- JP-U- 60 136 156
- KRAL A ET AL: "RF-CMOS oscillators with switched tuning" CUSTOM INTEGRATED CIRCUITS CONFERENCE, 1998. PROCEEDINGS OF THE IEEE 1998 SANTA CLARA, CA, USA 11-14 MAY 1998, NEW YORK, NY, USA,IEEE, US, 11 May 1998 (1998-05-11), pages 555-558, XP010293959 ISBN: 0-7803-4292-5
- PATENT ABSTRACTS OF JAPAN vol. 1996, no. 04, 30 April 1996 (1996-04-30) -& JP 07 336138 A (TAKESHI IKEDA), 22 December 1995 (1995-12-22)

## Description

The present invention relates to an LC oscillator that can be formed on various kinds of substrates such as a semiconductor substrate.

There is known a semiconductor circuit that forms a spiral pattern on a semiconductor substrate by using a thin film forming technique, and in which the pattern circuit serves as an inductor element. When current flows in such an inductor element that is formed on a semiconductor substrate, magnetic flux is generated in the direction perpendicular to the spiral pattern. However, eddy currents are induced on the front side of the semiconductor substrate by this magnetic flux resulting in cancellation of the effective magnetic flux so that the inductor element does not function effectively. In particular, the higher the frequency of a signal flowing in the inductor element, the more pronounced this effect becomes, and consequently it is difficult to form an LC oscillator, including the inductor element as a resonance element, on a semiconductor substrate.

JP-A-07336138 discloses an LC oscillator having an inductor element comprising first and second conductors mutually insulated and superimposed one on the other on a semiconductor substrate. Corresponding first ends of the conductors are connected together.

It is an object of the present invention to provide an LC oscillator that can perform oscillation even if the inductor element is formed on various kinds of substrates.

The present invention consists in an LC oscillator according to the appended claim 1.

It is experimentally confirmed that an inductor element that has such structure has predetermined inductance without losing an inductance component by eddy currents etc. even if the inductor element is formed on a substrate. With using this inductor element as a part of an LC oscillator, oscillation can be performed even if the LC oscillator is formed on the substrate.

In addition, as a substrate mentioned above, it is preferable to use a semiconductor substrate. In particular, if the inductor element that effectively functions can be formed on a semiconductor substrate, it is possible to form each configuration parts for LC oscillator, including the inductor element, on the semiconductor substrate. Hence it becomes possible to form the whole of the LC oscillator on the semiconductor substrate without using any external parts.

In addition, it is preferable to form two conductors as described above, in long shapes. Since an upper conductor never directly faces the front side of the substrate owing to making the two conductors the same in shapes, it is possible to reduce the eddy currents that are generated on the substrate when the upper conductor directly faces the substrate. In addition, it is possible to give predetermined inductance to the upper conductor by making the shapes of the two conductors long. In particular, since it is possible to give large inductance to a conductor when the conductor is formed in one or more turns of spiral shape or a meander shape, the conductor is suitable for being built in an LC oscillator having comparatively low oscillation frequency. In addition, since it is possible to give a small inductance to a conductor when the conductor is formed in a circular shape less than one turn or an substantially linear shape, the conductor is suitable for being built in an LC oscillator having comparatively high oscillation frequency.

Moreover, when two conductors are made in spiral shapes, it is preferable to connect an inner end of one conductor with an outer end of another conductor. Since it is experimentally confirmed that it is possible to secure further large inductance when an inductor conductor is formed on a substrate owing to performing such connection, it is possible to realize the inductor element that effectively functions on a substrate.

In addition, the inductor element described above is suitable for use as a compound element that also has a capacitance component besides an inductance component. Since this inductor element has two conductors, mutually superimposed, and a capacitance component is also included in its characteristics, the characteristics of this inductor element can be effectively used by using this inductor element as one part of the LC oscillator where an inductor and a capacitor are used in combination.
FIG. 1 is a circuit diagram showing a configuration of an LC oscillator according to an embodiment;
FIG. 2 is a schematic diagram showing a planar structure of an inductor element included in the LC oscillator shown in FIG. 1;
FIG. 3 is a schematic diagram showing the connections of two conductors shown in FIG. 2;
FIG. 4 is an expanded sectional view taken on a line IV-IV in FIG. 2;
FIG. 5 is a chart showing a measurement result of an output characteristic of an LC oscillator;
FIG. 6 is a chart showing a measurement result of an output characteristic of an LC oscillator;
FIG. 7 is a chart showing a measurement result of an output characteristic of an LC oscillator;
FIG. 8 is a chart showing a measurement result of an output characteristic of an LC oscillator;
FIG. 9 is a chart showing a measurement result of an output characteristic of an LC oscillator;
FIG. 10 is a chart showing a measurement result of an output characteristic of an LC oscillator; and
FIGs. 11A to 11C are schematic diagrams showing modified examples of the conductors included in inductor elements.

LC oscillators according to embodiments of the present invention will now be specifically described with reference to the accompanying drawings.

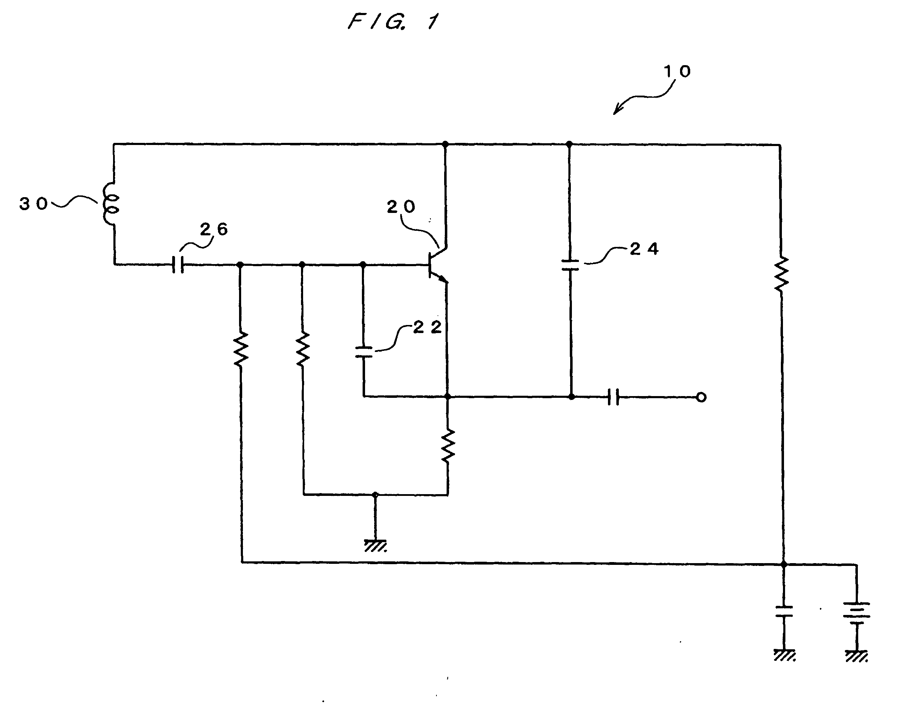

FIG. 1 is a circuit diagram showing a configuration of an LC oscillator according to an embodiment. An LC oscillator 10 shown in FIG. 1 has a transistor 20, a capacitor 22 connected between the base and the emitter of the transistor 20, a capacitor 24 connected between the emitter and the collector of the transistor 20, a capacitor 26 connected serially between the emitter and the collector of the transistor 20 and an inductor element 30.

In this LC oscillator, the capacitance of two capacitors 22 and 24 may be several tens times the between-terminal capacity of a transistor 20. In addition, an inductor element 30 is connected through a capacitor 26.

An LC oscillator 10 having the configuration described above in this embodiment is a Clapp circuit that is an advanced Colpitts circuit. In the LC oscillator 10, a capacitor of a resonant circuit that determines an oscillation frequency becomes equivalent to the series connection of capacitors 22, 24, and 26. Hence, it is possible to select larger capacitance of capacitors 22 and 24 than that of the Colpitts circuit that does not have a capacitor equivalent to the capacitor 26. Therefore, even if the capacitance between terminals of a transistor 20 changes, it does not give large influence to the resonant frequency of a resonant circuit, and hence it is possible to improve the stability of the oscillation frequency.

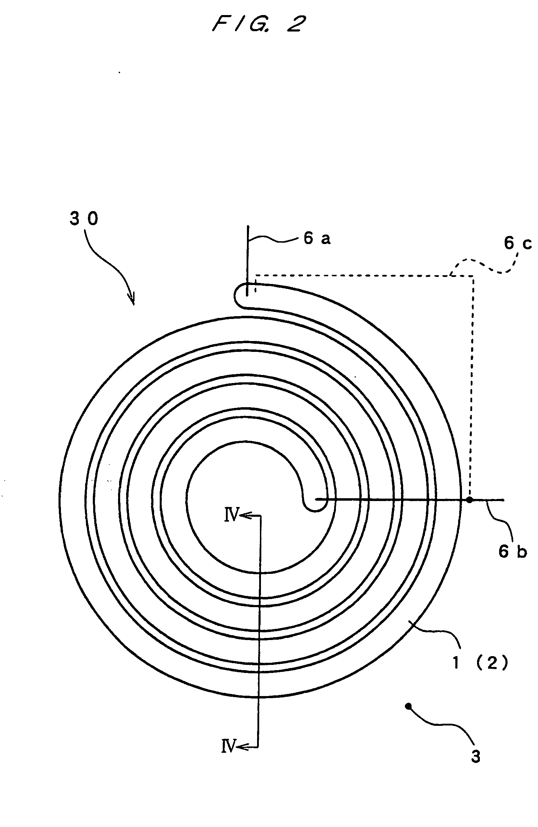

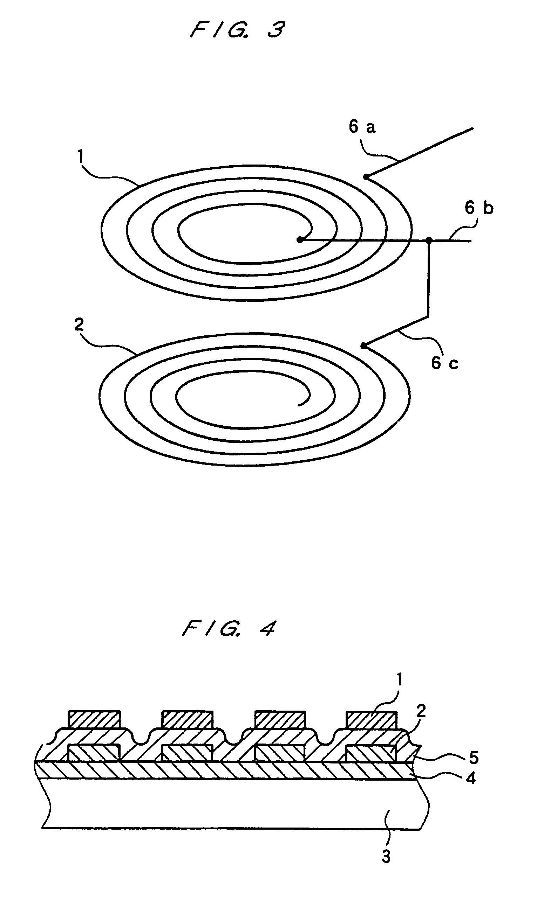

FIG. 2 is a schematic diagram showing a planar structure of an inductor element 30 included in the LC oscillator 10 according to this embodiment. An inductor element 30 has two conductors 1 and 2 that have spiral shapes and are formed in the front side of a semiconductor substrate 3.

These two conductors 1 and 2 have substantially the same shape. As shown in FIG. 2, when viewed from the front side of the semiconductor substrate 3, they are formed so that the conductor 1, which becomes an upper layer, and another conductor 2, which becomes a lower layer, are formed by being superimposed one on the other substantially exactly. Each of the conductors 1 and 2 is formed of a thin film of metal such as aluminum or gold, or semiconductor material such as poly silicon.

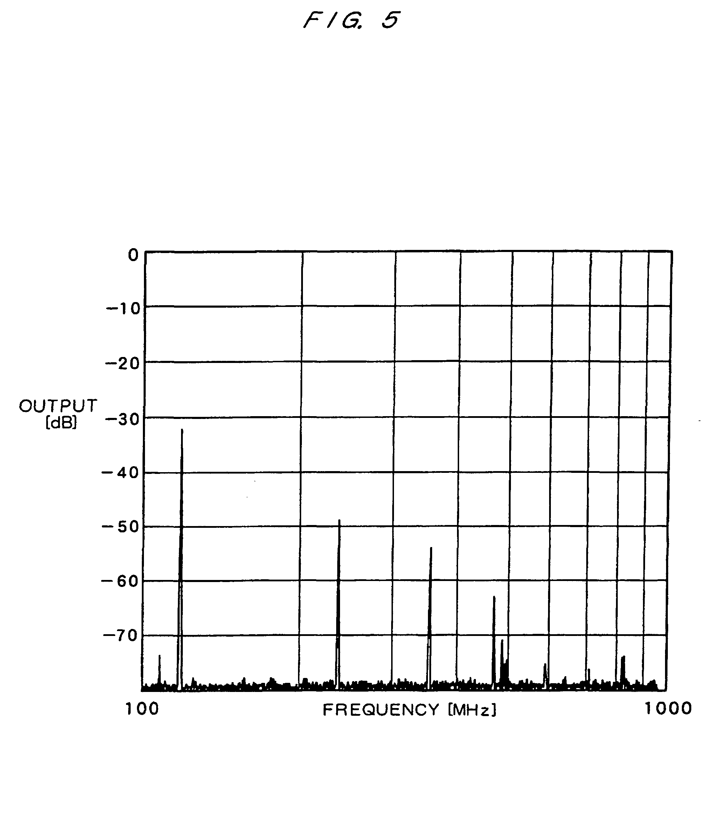

FIG. 3 is a schematic diagram showing a connection state of the two conductors 1 and 2, described above. As shown in FIG. 3, lead wires 6a and 6b are connected to an outer end (outer circumferential end) and an inner end (inner circumferential end) of the upper conductor 1 respectively, and the inner end of the upper conductor 1 and the outer end of the lower conductor 2 are connected with a connection wire 6c.

The upper conductor 1 functions as an inductor conductor, and is connected to the other configuration parts of the LC oscillator 10 formed on the semiconductor substrate 3 through the lead wires 6a and 6b connected to ends thereof.

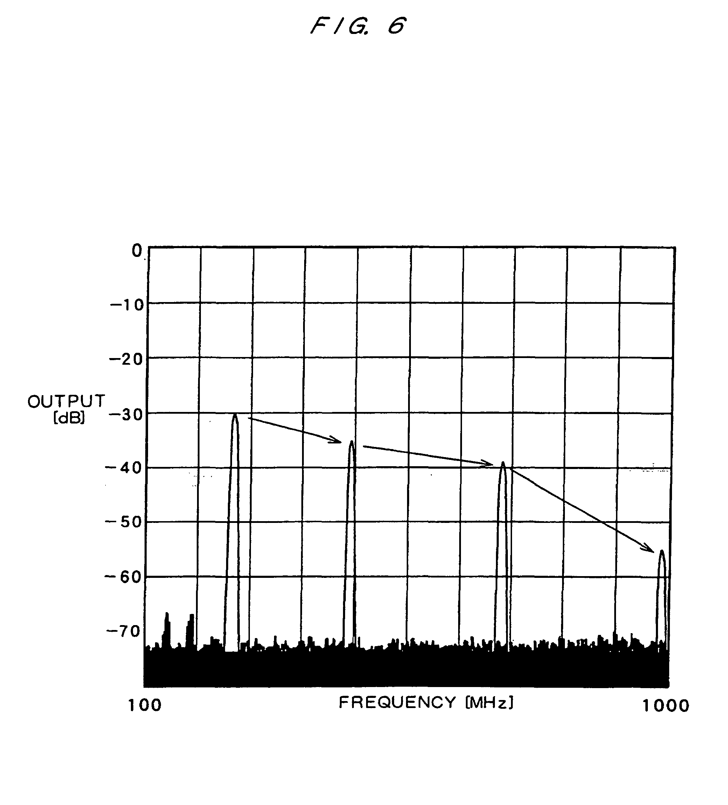

FIG. 4 is an expanded sectional view taken on a line IV-IV in FIG. 2. As shown in FIG. 4, an insulating layer 4 is formed on the front side of the semiconductor substrate 3, and the conductor 2 with a spiral shape is formed in a part of a top face of the insulating layer 4. In addition, an insulating layer 5 is formed on a top face of the insulating layer 4 and conductor 2, and the conductor 1 is formed on a top face thereof.

The inductor element 30 included in the LC oscillator 10 according to this embodiment has the structure described above. Since predetermined inductance appears between two lead wires 6a and 6b connected to both ends of the upper conductor 1 respectively, this upper conductor 1 can be used as an inductor conductor. In addition, under this upper conductor 1, the conductor 2 is formed which conductor has substantially the same shape as the conductor 1 . It is possible to suppress the generation of eddy currents in the front side of the semiconductor substrate 3 when an upper conductor 1 is used as an inductor conductor, by connecting one end of the upper conductor 1 with one end of the lower conductor 2 with the connection wire 6c. Hence, it is possible to make the upper conductor 1 effectively function as an inductor conductor. Therefore, it becomes possible to integrate the entire LC oscillator 10, including the inductor element 30, in one piece on the semiconductor substrate 3.

Next, the result of a comparative experiments for estimating the characteristics of the inductor element 30 according to this embodiment described above will be described.

FIG. 5 is a graph showing the measurement result of the output characteristics of an LC oscillator which is configured with an inductor element which has an electrode of one layer having the same shape as the conductor 1 included in the inductor element 30. As for the inductor element used in this measurement of the output characteristics, a five-turn electrode having one-mm pattern width and a 0.2-mm adjacent gap of spiral pattern was formed on a front side of a 0.13-mm-thick insulating member with a dielectric constant of 3.17. In addition, vertical axes in FIG. 5 (this is the same also in FIGs. 6 through 10 which are described later) denote output amplitudes logarithmically expressed, and horizontal axes denote the frequencies of output signals logarithmically expressed, respectively. As shown in FIG. 5, an oscillation frequency of 119 MHz was observed when the LC oscillator performs in the state with sufficiently separating the inductor element including such an electrode of one layer from other conductor substrate or semiconductor substrate.

FIG. 6 is a graph showing the output characteristic of an LC oscillator at the time of gradually bringing a copper plate, which is a conductive substrate, close to the inductor element used for the measurement of the output characteristics shown in FIG. 5. As shown in FIG. 6, it was observed that, when the copper plate was gradually brought close to this inductor element in the state of oscillation when using the inductor element comprising one layer of electrode, the oscillation frequency became higher from 118 MHz to 139 MHz, 168 MHz, or 198 MHz. Furthermore, it was observed that oscillation stopped when the copper plate was closely contacted to the electrode with a sandwiching insulating member having the thickness of 3.17 mm.

Thus, if an inductor element simply made of one layer of electrode in a spiral shape is adopted and is formed on a copper plate, oscillating operation of an LC oscillator stops. This is because the inductance that the inductor element comprising one layer of electrode has becomes small by making the copper plate approach the inductor element. The reason why the inductance becomes small when the copper plate is made to approach the inductor element may be that eddy currents arise on a surface of the copper plate owing to the magnetic flux generated when a signal is inputted into an electrode to cancel this magnetic flux.

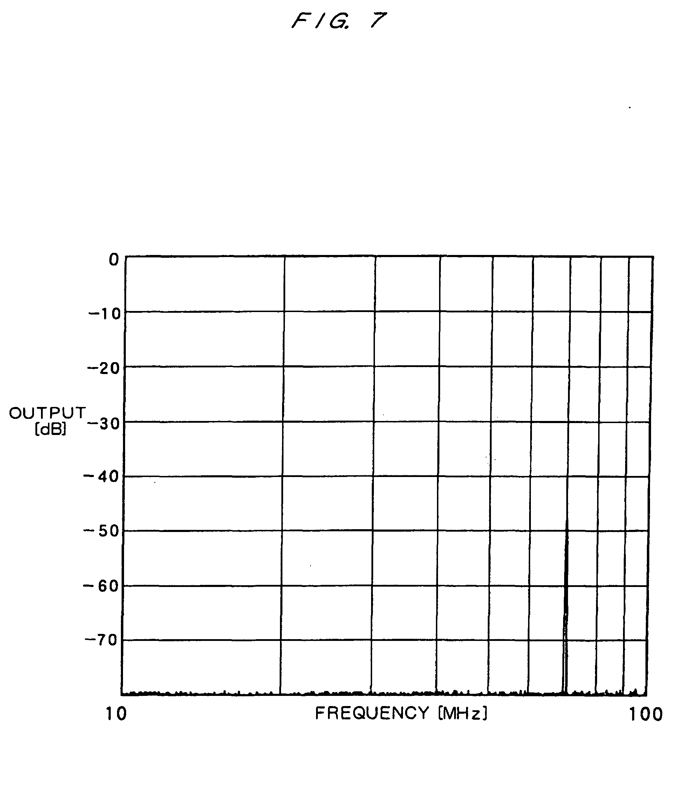

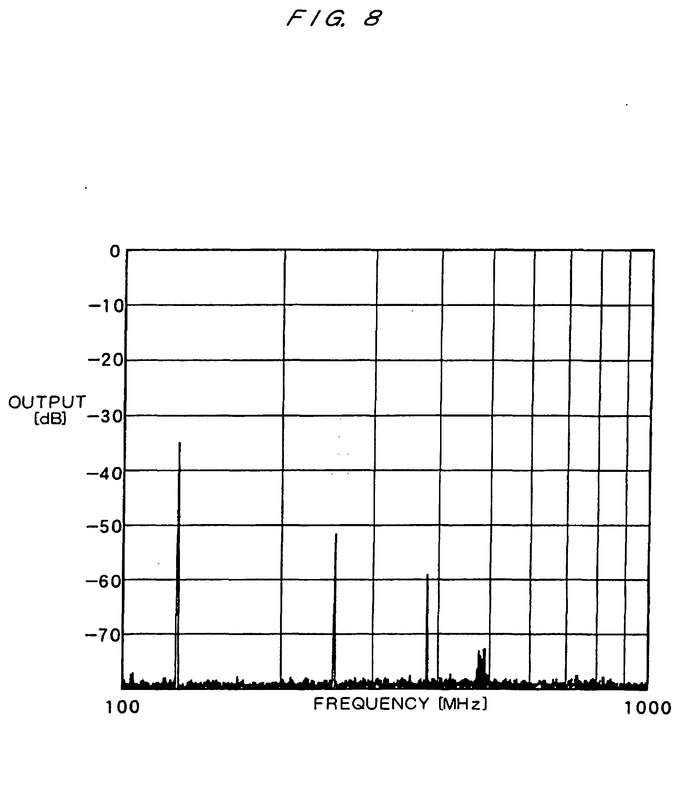

FIG. 7 is a graph showing the measurement result of the output characteristic in the case of configuring an LC oscillator with using two layers of electrodes that have the same shape and arrangement as two conductors 1 and 2 included in the inductor element 30 shown in FIG. 2. In addition, FIG. 8 is a graph showing the output characteristic of an LC oscillator in the case of closely contacting a copper plate to an inductor element having the same shape and arrangement as two conductors 1 and 2 included in the inductor element 30.

The inductor element used for these measurements has a structure comprising an electrode corresponding to the conductor 2, shown in FIG. 2, added to the inductor element of the oscillator for which the measurement results are shown in FIGs. 5 and 6. In addition, if closely contacting the copper plate to this inductor element, the lower electrode and copper plate are arranged through an adequate thin insulating member.

With an inductor element sufficiently separated from other conductive members, an LC oscillator using the inductor element, where two layers of spiral electrodes are located facing each other has an oscillation frequency near 70 MHz, as seen from the measurement result shown in FIG. 7. This oscillation frequency is lower than the oscillation frequency (119 MHz) shown in FIG. 5 for an oscillator in which the inductor element comprises one layer of electrode because the inductor element comprising two layers of electrodes functions as a compound device which has an inductance component and a capacitance component. This capacitance component lowers a resonant frequency of the resonant circuit including the inductor element.

In addition, when closely contacting the inductor element having the electrode of two layers mentioned above to the copper plate, a similar result occurs although the position of a oscillation frequency (127MHz) shifts as shown in FIG. 8. This shows that, by using the inductor element that has the double structure of the electrodes described above, even if the inductor element is closely contacting to the copper plate, the inductance component does not disappear and the function as an inductor conductor is maintained.

Thus, the inductor element made by forming two layers of electrodes in a spiral shape functions as an inductor conductor without the inductance component disappearing even if a copper plate is closely contacted to one (the electrode opposite to the electrode used as an inductor conductor) of them, and the oscillating operation of the LC oscillator where this is used is maintained. Hence, even if each component of the LC oscillator 10 including this inductor conductor 30 is formed on the semiconductor substrate 3, it is possible to make the LC oscillator 10 perform oscillating operation by using the inductor element 30 in this embodiment which has the fundamentally same structure.

The present invention is not limited to the above-described embodiment, but various types of modifications are possible within the scope of the present invention. For example, in the inductor element 10 shown in FIGs. 2 and 3, the inner end of the upper conductor 1 and the outer end of the lower conductor 2 are connected through the connection wire 6c. Nevertheless, on the contrary, it can be also performed to mutually connect the outer end of the upper conductor 1 and the inner end of the lower conductor 2. In addition, it would also be possible to connect either outer ends or both inner ends of conductors 1 and 2 when it is allowed that the inductance of an inductor element becomes small to some extent, but this lies outside the scope of the present invention.

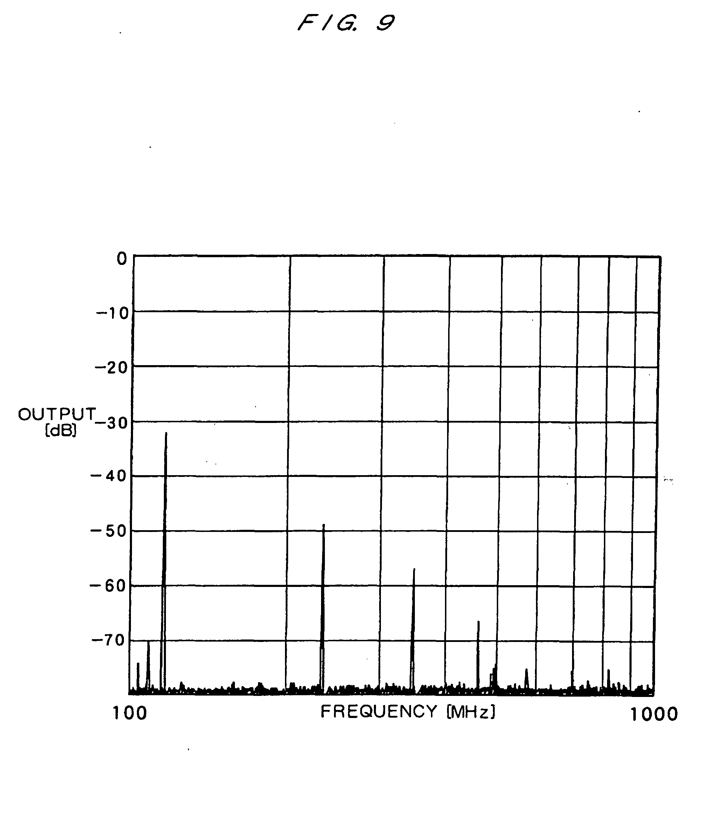

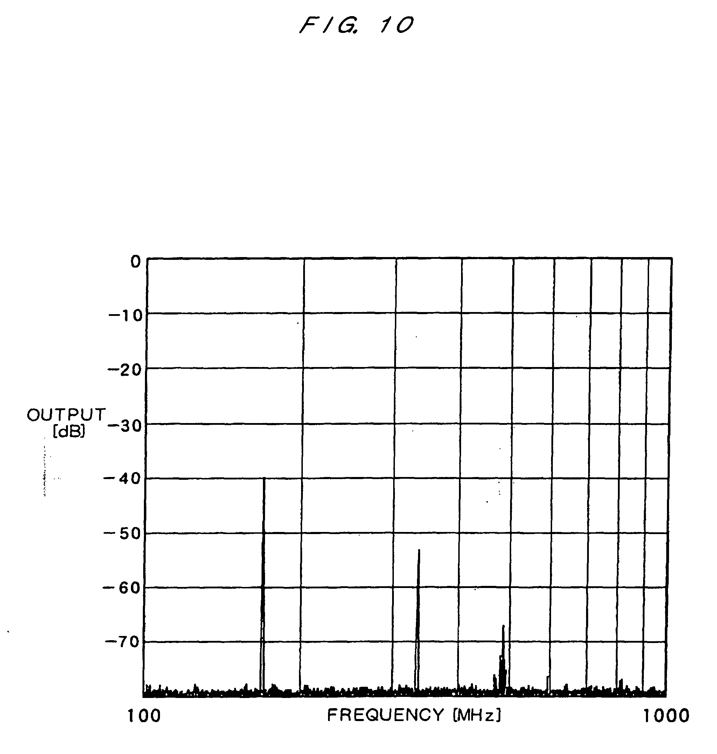

For the purpose of more adequately explaining the invention, FIG. 9 shows a graph showing a measurement result of the output characteristic in the case of configuring an LC oscillator using an inductor element that has two layers of electrodes in the same shape and arrangement as two conductors 1 and 2 included in the inductor element 30 shown in FIG. 2 and in which each outer circumferential end of the two electrodes is mutually connected. Also for the purpose of explaining the invention, FIG. 10 shows a graph showing the measurement result of the output characteristic of the LC oscillator at the time of closely contacting the copper plate to the inductor element used for the characteristic measurement shown in FIG. 9. As shown in these figures, in the LC oscillator where the inductor element in which both outer circumferential ends of two electrodes are mutually connected is used, its oscillation frequency changes from 117 MHz to 171 MHz by closely contacting the copper plate. Nevertheless, oscillating operation is maintained without stopping.

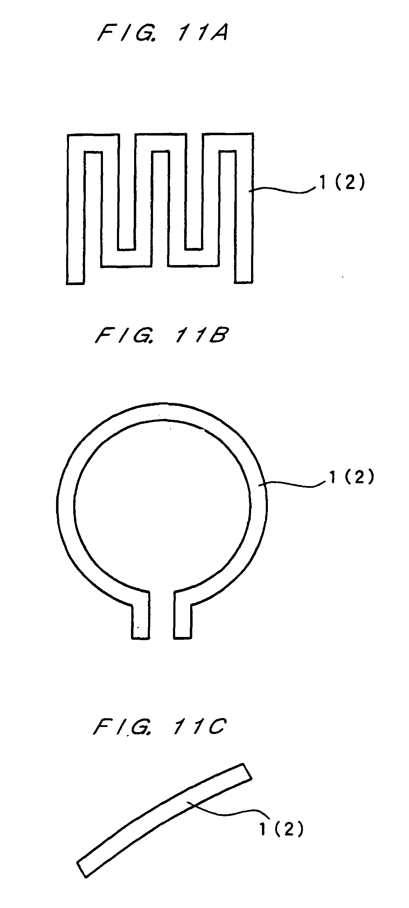

Additionally , since two conductors 1 and 2 included in the inductor element 30 are formed in spiral shapes in the embodiment described above, it is possible to realize the inductor element 30 having large inductance. Nevertheless, it is also good to form two conductors 1 and 2 in meander shapes (FIG. 11A). In addition, the inductance of this inductor element 30 can be small when it is used as one part of a high frequency oscillator. Hence it is also good to form the inductor element 30 less than one turn by reducing the numbers of turns of the conductors 1 and 2 (FIG. 11B), or to form it in an substantially linear shape (FIG. 11C).

Furthermore , although the shapes of two conductors 1 and 2 are set substantially similarly in the embodiment described above, it is also good to set them in different shapes. For example, it can be also performed to set the number of turns of the lower conductor 2 to be more than that of the upper conductor 1. Thus, since the upper conductor 1 does not directly face the semiconductor substrate 3 if all or some of the lower conductor 2 is arranged under the upper conductor 1, it is possible to effectively prevent the generation of eddy currents due to the upper conductor 1.

Also , although the inductor element 30 is formed by forming two conductors 1 and 2 on the semiconductor substrate 3 in the embodiment described above, the inductor element 30 in which two conductors 1 and 2 are formed on a conductor substrate such as a metal is also realizable. From the experimental result shown in FIG. 8, it is confirmed that, even in this case, this effectively functions as the inductor element 30 and that the LC oscillator performs oscillation. If it becomes possible to form the inductor element 30 by closely contacting it on a conductor substrate, it also becomes possible to arrange the inductor element 30 on a front side of a metal shielding case or the like. Hence, it becomes easy to secure an installation space of the inductor element.

Furthermore, although a Clapp circuit is used as an LC oscillator in the embodiments described above, it is also good to use another LC oscillator, such as a Colpitts circuit that enables oscillating operation, where the resonance of an inductor and a capacitor is used . Even in this case, by using an inductor element having the structure shown in FIG. 2 etc. as an inductor element included in the LC oscillator, it is possible to realize an LC oscillator which performs oscillating operation on a semiconductor substrate or a conductor substrate.

As described above, by forming two conductors one on the other on a substrate and connecting one end of one conductor with one end of the other, it is possible to use an upper conductor as an inductor conductor having predetermined inductance. Therefore, by using this inductor element as a part of an LC oscillator, oscillation can be performed even if the LC oscillator is formed on the substrate. In particular, according to one embodiment, since the inductor element effectively functions on a semiconductor substrate , it becomes possible to integrate a whole LCoscillator including an inductor, which is impossible up to now.

## Claims

1. An LC oscillator having an inductor element (30) formed on a substrate (3), the inductor element comprising first and second conductors (1,2) which are mutually insulated and which have substantially the same shape with corresponding first and second ends, wherein the inductance of the inductor element (30) appears between the two ends of the first conductor (1) and wherein the first and second conductors (1,2) are superimposed one on the other on a face of the substrate (3) with the second conductor (2) disposed between the first conductor (1) and the substrate (3), **characterised in that** the first end of the first conductor (1) is connected to the second end of the second conductor (2).

2. An LC oscillator as claimed in claim 1, where the substrate (3) is a semiconductor substrate (3), and components are formed on the substrate on which the inductor element (30) is formed.

3. An LC oscillator as claimed in claim 1, or 2, wherein said two conductors (1,2) have long shapes, and the first end of the first conductor (1) in a longitudinal direction is connected with the second end of the second conductor (2) in the longitudinal direction.

4. An LC oscillator as claimed in claim 1 or 2, wherein said two conductors (1,2) are circular in shape and have less than one turn.

5. An LC oscillator as claimed in claim 1 or 2, wherein said two conductors (1,2) are spiral in shape and have one or more turns.

6. An LC oscillator as claimed in claim 1 or 2, wherein the two conductors are formed in substantially linear shapes.

7. An LC oscillator as claimed in claim 1 or 2, wherein the two conductors are formed in meander shapes.

8. An LC oscillator as claimed in claim 5, wherein said corresponding first and second ends of the conductors (1,2) comprise either inner and outer ends, respectively, or outer and inner ends, respectively.

9. An LC oscillator as claimed In any one of the preceding claims, including an inductance component of the first conductor (1); and a capacitance component between the two conductors (1,2).

## Patentansprüche

1. LC-Oszillator mit einem auf einem Substrat (3) ausgebildeten Induktionsspulenelement (30), wobei das Induktionsspulenelement einen ersten und einen zweiten Leiter (1, 2) aufweist, die wechselseitig isoliert sind und die im Wesentlichen dieselbe Form mit entsprechenden ersten und zweiten Enden haben, wobei die Induktivität des Induktionsspulenelements (30) zwischen den zwei Enden des ersten Leiters (1) erscheint und wobei der erste und der zweite Leiter (1, 2) auf einer Fläche des Substrats (3) einander überlagert sind, wobei der zweite Leiter (2) zwischen dem ersten Leiter (1) und dem Substrat (3) angeordnet ist, **dadurch gekennzeichnet, dass** das erste Ende des ersten Leiters (1) mit dem zweiten Ende des zweiten Leiters (2) verbunden ist.

2. LC-Oszillator nach Anspruch 1, wobei das Substrat (3) ein Halbleitersubstrat (3) ist und Bauteile auf dem Substrat ausgebildet sind, auf welchem das Induktionsspulenelement (30) ausgebildet ist.

3. LC-Oszillator nach Anspruch 1 oder 2, wobei die zwei Leiter (1, 2) lange Formen haben und das erste Ende des ersten Leiters (1) in einer Längsrichtung mit dem zweiten Ende des zweiten Leiters (2) in der Längsrichtung verbunden ist.

4. LC-Oszillator nach Anspruch 1 oder 2, wobei die zwei Leiter (1, 2) bezüglich der Form kreisförmig sind und weniger als eine Windung haben.

5. LC-Oszillator nach Anspruch 1 oder 2, wobei die zwei Leiter (1, 2) bezüglich der Form spiralförmig sind und eine oder mehrere Windungen haben.

6. LC-Oszillator nach Anspruch 1 oder 2, wobei die zwei Leiter in im Wesentlichen linearen Formen ausgebildet sind.

7. LC-Oszillator nach Anspruch 1 oder 2, wobei die zwei Leiter in Mäanderformen ausgebildet sind.

8. LC-Oszillator nach Anspruch 5 wobei die entsprechenden ersten und zweiten Enden der Leiter (1, 2) entweder jeweils innere und äußere Enden oder jeweils äußere und innere Enden aufweisen.

9. LC-Oszillator nach einem der vorangehenden Ansprüche, der eine Induktionsspulenkomponente des ersten Leiters (1) und eine Kapazitätskomponente zwischen den zwei Leitern (1, 2) enthält.

## Revendications

1. Oscillateur LC ayant un élément d'inductance (30) formé sur un substrat (3), l'élément d'inductance comprenant des premier et second conducteurs (1, 2) qui sont mutuellement isolés et qui présentent sensiblement la même forme que les première et seconde extrémités correspondantes, dans lequel l'inductance de l'élément d'inductance (30) apparaît entre les deux extrémités du premier conducteur (1), et dans lequel les premier et second conducteurs (1, 2) sont superposés l'un sur l'autre sur une face du substrat (3) avec le second conducteur (2) placé entre le premier conducteur (1) et le substrat (3), **caractérisé en ce que** la première extrémité du premier conducteur (1) est connectée à la seconde extrémité du second conducteur (2).

2. Oscillateur LC selon la revendication 1, dans lequel le substrat (3) est un substrat (3) semiconducteur, et des composants sont formés sur le substrat sur lequel est formé l'élément d'inductance (30).

3. Oscillateur LC selon la revendication 1 ou 2, dans lequel lesdits deux conducteurs (1, 2) ont des formes longues, et la première extrémité du premier conducteur (1) dans un sens longitudinal est connectée à la seconde extrémité du second conducteur (2) dans le sens longitudinal.

4. Oscillateur LC selon la revendication 1 ou 2, dans lequel lesdits deux conducteurs (1, 2) sont de forme circulaire et présentent moins d'une spire.

5. Oscillateur LC selon la revendication 1 ou 2, dans lequel lesdits deux conducteurs (1, 2) sont en forme de spirale et présentent une ou plusieurs spires.

6. Oscillateur LC selon la revendication 1 ou 2, dans lequel les deux conducteurs sont configurés dans des formes sensiblement linéaires.

7. Oscillateur LC selon la revendication 1 ou 2, dans lequel les deux conducteurs sont configurés en forme de méandre.

8. Oscillateur LC selon la revendication 5, dans lequel lesdites première et seconde extrémités correspondantes des conducteurs (1, 2) comprennent soit des extrémités internes et externes respectivement, soit des extrémités externes et internes respectivement.

9. Oscillateur LC selon l'une quelconque des revendications précédentes, comprenant un composant d'inductance du premier conducteur (1) ; et un composant de capacité entre les deux conducteurs (1, 2).
